# EUROPÄISCHE PATENTANMELDUNG

(11) **EP 4 704 502 A1**
(43) Veröffentlichungstag der Anmeldung: **04.03.2026**
(21) Anmeldenummer: 24197134.0
(22) Anmeldetag: 29.08.2024
(51) Int. Cl.: H05K 7/14, H05K 9/00

(54) **SYSTEM AUS EINER ELEKTRONISCHEN LEITERPLATTE UND EINEM TRÄGERRAHMEN**

(71) Anmelder: Siemens Aktiengesellschaft, 80333 München (DE)
(72) Erfinder: Franke, Martin, 14089 Berlin (DE); Jeske, Nora, 10555 Berlin (DE); Müller, Bernd, 16259 Falkenberg (DE); Raab, Oliver, 94496 Ortenburg (DE); Schwarz, Markus, 78199 Bräunlingen (DE); Weikert, Robert, 92342 Burggriesbach (DE)
(74) Vertreter: Siemens Patent Attorneys

(57) **Zusammenfassung**

Die vorliegende Erfindung betrifft ein System aus einer elektronischen Leiterplatte und einem die Leiterplatte aufnehmenden Trägerrahmen.

## Beschreibung

Die vorliegende Erfindung betrifft ein System aus einer elektronischen Leiterplatte und einem die Leiterplatte aufnehmenden Trägerrahmen.

Ein Großteil des CO₂-Fußabdrucks eines Elektronikprodukts wird derzeit durch Leiterplatten verursacht. Die Nachhaltigkeit dieser für unser tägliches Leben unverzichtbaren Bauteile ist aber verbesserungswürdig, da sowohl die zur Herstellung notwendigen energetischen Ressourcen als auch die bei der Fertigung eingesetzten Materialien nur bedingt als umweltfreundlich oder umweltgerecht anzusehen sind. So erschwert der in der Fertigung verwendete Materialmix der Leiterplatten oder -platinen in Kombination mit den technisch notwendigerweise zu verwendenden Harzsystemen eine Wiederverwendbarkeit oder Recyclingfähigkeit der Leiterplatte deutlich. Letzteres gilt insbesondere für gedruckte Leiterplatten (PCBs, "printed circuit boards"), in deren Fertigung ein nicht unerheblicher Anteil an Materialverwurf entsteht, da Nutzenränder zum Abschluss der Fertigung entfernt und entsorgt werden müssen.

Fertigungstechnisch und in Bezug auf die Nachhaltigkeit gibt es bisher zu den bestehenden Systemen kaum kompetitive Wahlmöglichkeiten. Eine Miniaturisierung der Leiterplatten kann zwar prinzipiell angestrebt werden, diese ist aber aufgrund der verwendeten elektronischen Komponenten oder unter Berücksichtigung der geometrischen Produktvorgaben nicht immer sinnvoll oder gar realisierbar. Insofern wird an Alternativmaterialien für den bestehenden Grundaufbau der PCB-Leiterplatten geforscht. Ein Material, welches gleichzeitig den physikalischen Anforderungen in der Fertigung und den Feuchte- und Temperaturbedingungen über lange Anwendungszeiträume hinreichend widerstehen kann, ist aber zur Zeit noch nicht realisiert oder in Sicht.

Vor diesem Hintergrund des Standes der Technik ist es daher Aufgabe der Erfindung, ein verbessertes System aus einer Leiterplatte und einem Aufnahmerahmen für die Leiterplatte zu schaffen, welches in der Lage ist, den CO₂-Fußabdruck des Einsatzes von Leiterplatten in der Herstellung von Elektrogeräten zu verkleinern. Insbesondere ist es die Aufgabe des erfindungsgemäßen Systems, sowohl den CO₂-Fußabdruck als auch die Recyclingquote für Elektrogeräte mit Leiterplatten zu verbessern.

Die Aufgabe der Erfindung wird mit einem System aus einer elektronischen Leiterplatte und einem Aufnahmerahmen mit den in Anspruch 1 angegebenen Merkmalen gelöst.

Bevorzugte Weiterbildungen der Erfindung sind in den zugehörigen Unteransprüchen, der nachfolgenden Beschreibung und der Zeichnung angegeben.

Das erfindungsgemäße System ist ein System aus einer elektronischen Leiterplatte und einem Aufnahmerahmen, wobei die elektronische Leiterplatte eine Trägerplatte mit zwei Oberflächenbereichen und einem die Trägerplatte begrenzenden, umlaufenden Randbereich umfasst, wobei auf mindestens einem der Oberflächenbereiche der Trägerplatte elektronische Bauteile anordbar sind, wobei der Aufnahmerahmen den umlaufenden Randbereich der Trägerplatte zu einem Anteil von größer oder gleich 50% bezogen auf den Gesamtumfang des Randbereiches kontaktiert, wobei das Material des Aufnahmerahmens ausgesucht ist aus der Gruppe bestehend aus Metallen, Kunststoffen, biologisch abbaubaren Kunststoffen oder Mischungen mindestens zweier Komponenten aus dieser Liste.

Mittels des erfindungsgemäßen Systems können erhebliche Mengen an Leiterplatten-Material eingespart werden. Durch die Materialeinsparungen wird ein wesentlicher Beitrag zur Nachhaltigkeit der Leiterplatte als solche und für das diese enthaltende, elektronische Endprodukt geleistet. Die Einsparungen können erfolgen, da durch das System aus Leiterplatte und Aufnahmerahmen die Leiterplatten unabhängig von den geometrischen Vorgaben des Gesamtgerätes maximal klein ausgestaltet werden können. Der Aufnahmerahmen kann zudem zweckmäßigerweise in der entsprechenden Geometrie zum Einfügen oder zur Anbindung des Systems in das elektrische Gerät ausgestaltet sein. So können auch sehr kleine Leiterplatten mit der entsprechenden funktionalen Anbindung an das elektronische Gerät ausgestaltet werden. Das Design und die Ausführung der Leiterplatte wird also weitgehend von den mechanischen und funktionalen Voraussetzungen des elektronischen Geräts entkoppelt und über die Trennung zwischen elektronischer Leiterplatte und Aufnahmerahmen ergeben sich Optimierungsmöglichkeiten hinsichtlich der Materialauswahl und der physikalischen Eigenschaften der einzelnen Systembestandteile. Es können mittels des Aufnahmerahmens zusätzliche mechanische oder elektrische Funktionen bereitgestellt werden, welche sich nicht so oder nicht so einfach und kostengünstig in oder auf der Leiterplatte realisieren lassen. Der Aufnahmerahmen ist zudem nicht den Randbedingungen der begrenzten Leiterplatten-Herstellungsweise unterworfen, sodass es prinzipiell möglich ist, dass der Aufnahmerahmen flexibel in Form eines 3D-Formbauteils, beispielsweise gefertigt über 3D-Druck, bereitgestellt werden kann. Weiterhin kann es vorteilhaft sein, dass über einen Aufnahmerahmen mehrere unbestückte Leiterplatten in der Fertigung mechanisch gehalten und parallel gefertigt und/oder bestückt werden können. Letzteres kann die Produktionslogistik deutlich vereinfachen und die Kosten senken.

Das System umfasst eine elektronische Leiterplatte und einen Aufnahmerahmen. Das System weist mindestens eine elektronische Leiterplatte oder Platine auf, beispielsweise in Form einer gedruckten elektronischen Leiterplatte. Die Leiterplatte umfasst eine Trägerplatte, welche als mechanischer Träger zur Fixierung elektronischer Bauteile dient. Die Trägerplatte gewährleistet auch die elektrische Kontaktierung der einzelnen Bauteile. Leiterplatten bestehen dazu üblicherweise aus einem elektrischen isolierenden Grundmaterial in Form einer dünnen Schicht oder Platte, auf dessen Oberfläche die elektrischen Verbindungen zwischen den elektrischen Bauteilen in Form von Leiterbahnen aufgebracht sind. Als isolierendes Material der Platte wird üblicherweise ein faserverstärkter Kunststoff eingesetzt, wobei die Leiterbahnen zumeist aus einer dünnen Kupferschicht geformt werden. Es können ein- oder mehrlagige Leiterplatten und Leiterplatten mit unterschiedlichen Abmessungen und Geometrien eingesetzt werden.

Die elektronische Leiterplatte umfasst eine Trägerplatte mit zwei Oberflächenbereichen und einem die Leiterplatte begrenzenden, umlaufenden Randbereich. Die Leiterplatte ist in Form einer ebenen Trägerplatte ausgeformt, wobei die Schichthöhe deutlich geringer ist als die Länge und Breite der Platte. Der Begriff Trägerplatte bezeichnet in dieser Anmeldung die Platte als solche, ohne elektrische Bestückung. Durch das Aufbringen elektronischer Komponenten wird aus der Trägerplatte ("printed circuit board" PCB) eine bestückte Leiterplatte ("printed circuit board assembly" PCBA). Die Platte wird über zwei gegenüberliegende Oberflächenbereiche auf der Ober- sowie Unterseite der Platte und einen diese Oberflächenbereiche verbindenden Randbereich definiert. Der Randbereich erstreckt sich an entlang der Außenkanten der Trägerplatte. Eine Leiterplatte kann beispielsweise eine rechteckige oder quadratische Grundform aufweisen. Übliche Schichtdicken elektronischer Leiterplatten können beispielsweise von 0,5 mm bis zu 10 mm betragen. Die Oberflächen können beispielsweise größer oder gleich 10 cm², bevorzugt größer oder gleich 25 cm² und weiterhin bevorzug größer oder gleich 50 cm² groß sein.

Auf mindestens einem der Oberflächenbereiche der Trägerplatte sind elektronische Bauteile anordbar. Die Leiterplatte weist auf mindestens einem der Oberflächenbereiche eine Vorbereitung zur Aufbringung elektrischer Leitungsstrukturen oder schon Leitungsstrukturen in Form von Leiterbahnen auf. Zudem weist die Trägerplatte eine Vorbereitung zur mechanischen Befestigung eines oder mehrerer elektrischer Bauteile, wie beispielsweise Widerstände, Kondensatoren, ICs oder ähnlich auf. Es ist auch möglich, dass sowohl Leiterbahnen wie auch elektrische Bauteile schon auf der Trägerplatte positioniert sind.

Der Aufnahmerahmen kontaktiert den umlaufenden Randbereich der Trägerplatte zu einem Anteil von größer oder gleich 50% bezogen auf den Gesamtumfang des Randbereiches. Die Trägerplatte ist im Aufnahmerahmen angeordnet und der Randbereich der Trägerplatte wird zumindest im oben angegebenen Umfang umfasst. Dazu kann der Aufnahmerahmen die Trägerplatte an dem Randbereich der Trägerplatte mechanisch kontaktieren. Alternativ kann der Aufnahmerahmen auch den Randbereich der Trägerplatte im oben angegebenen Umfang umfassen. Im letzteren Fall kontaktiert der Aufnahmerahmen die Trägerplatte nicht direkt am umlaufenden Trägerplattenrand, sondern an einer oder beiden Oberflächenbereichen der Trägerplatte. Der Gesamtumfang der Trägerplatte ergibt sich als Summe der Längen der Außenkanten der Trägerplatte. Die Kontaktlänge ergibt sich aus der Summe der Länge der Streckenabschnitte der Trägerplatte, welche einen direkten mechanischen Kontakt zum Aufnahmerahmen aufweisen oder, alternativ, aus der Summe der Länge der Streckenabschnitte des umlaufenden Randbereichs der Trägerplatte, welche vom Aufnahmerahmen zu einem oder beiden Oberflächenbereichen umfasst werden. Eine Kontaktierung kann insofern auch dadurch erreicht werden, indem die Leiterplatte mit einer Oberflächenseite auf dem Aufnahmerahmen aufliegt. Falls sowohl eine direkte Kontaktierung als auch eine Umfassung der Randbereiche der Trägerplatte erfolgt, so ergibt sich der Parameter aus der Summe der Längen sowohl der mechanisch kontaktierten als auch der umfassten Oberflächenbereiche.

Das Material des Aufnahmerahmens ist aus der Gruppe bestehend aus Metallen, Kunststoffen, biologisch abbaubaren Kunststoffen oder Mischungen mindestens zweier Komponenten aus dieser Liste ausgesucht. Das Material des Aufnahmerahmens kann unabhängig von den funktionellen Materialvorgaben der Trägerplatte gewählt werden, da der Aufnahmerahmen in der Regel keine elektrischen Bauteile tragen muss. Durch die größere Materialwahl können andere Aspekte, wie die Nachhaltigkeit, der CO₂-Fußabdruck oder die Recyclingfähigkeit in den Vordergrund treten. Hierfür kann es zweckmäßig sein, dass der Trägerrahmen beispielsweise aus einem Kunststoff gefertigt ist. Die Kunststoffe können beispielsweise aus der Gruppe der Thermoplaste oder Duroplaste ausgewählt sein. Bevorzugt können duroplastische Kunststoffe ausgewählt werden. Zu diesen Kunststoffen zählen beispielsweise Polyurethane (PUR), Phenolharze, Harnstoff- und Melaminharze, Polyesterharze, Epoxidharze, Silikone. Zur Verbesserung der Nachhaltigkeit können auch biologisch abbaubare Kunststoffe eingesetzt werden. So kann der Trägerahmen beispielsweise aus Polycaprolacton (PCL), Polybutylenadipat-Terephthalat (PBAT), thermoplastischer Stärke, Cellulose, abbaubaren Polyestern, Polylactid (PLA) oder aus fossilbasiertem Polybutylensuccinat (PBS) bestehen oder diese zu Anteilen enthalten. Ein Kunststoff ist im Sinne der Erfindung bioabbaubar, wenn eine Probe umgeben von Wasser innerhalb von 6 Monaten zu 90 % in Abbauprodukte wie CO₂ umgewandelt wurde. Zur Integration weiterer Funktionalitäten in den Aufnahmerahmen kann dieser beispielsweise auch aus einem Metall gefertigt sein. Metall ermöglicht im Vergleich zu den Kunststoffen eine verbesserte Wärmeableitung sowie ggf. Abschirmung der elektrischen Bauteile auf der Trägerplatte. Geeignete Metalle sind beispielsweise Kupfer, Eisen oder Stahl oder Aluminium. Es können auch Metall-Legierungen eingesetzt werden.

In einer weiter bevorzugten Ausgestaltung des Systems kann der Aufnahmerahmen den umlaufenden Randbereich der Trägerplatte vollständig kontaktieren. Eine besonders sichere mechanische und thermische Kontaktierung kann in den Fällen erreicht werden, in welchen die Trägerplatte am umlaufenden Rand vollständig den Aufnahmerahmen kontaktiert. Die Trägerplatte ist also vollständig in den Aufnahmerahmen eingepasst, wird an den Randbereichen von diesem umgeben und steht im physischen Kontakt zu diesem. In dieser Ausgestaltung ist es unschädlich, wenn aufgrund von Fertigungstoleranzen der Trägerplatte oder des Aufnahmerahmens eine Strecke von 5%, bezogen auf den Gesamtumfang der Trägerplatte, der Trägerplatte den Aufnahmerahmen nicht kontaktiert.

In einer weiter bevorzugten Ausgestaltung des Systems kann der Aufnahmerahmen die Trägerplatte zumindest abschnittweise an beiden Oberflächenbereichen kontaktieren. Neben der möglichen mechanischen Kontaktierung über den Randbereich der Trägerplatte kann ein sicheres mechanisches Halten der Trägerplatte durch den Aufnahmerahmen auch über eine Kontaktierung der Trägerplatte an einer oder beiden Oberflächenbereichen erfolgen. Hierzu ergibt sich ein direkter Kontakt des Aufnahmerahmens mit randnahen Oberflächenbereichen der Trägerplatte. Die Trägerplatte kann demzufolge mit einem Teilbereich der Oberfläche auf dem Aufnahmerahmen aufliegen, oder der Aufnahmerahmen kann beispielsweise eine Nut aufweisen, in welche die Trägerplatte eingepasst wird. Zur Kontaktierung wird somit nicht zwangsläufig ein Kontakt zum eigentlichen Randbereich der Trägerplatte hergestellt. Bevorzugt kann der Kontakt zu einem randnahen Bereich der Trägerplatte ausgebildet werden, wobei der Randbereich sich bevorzugt größer oder gleich 1 mm und kleiner oder gleich 20 mm, weiter bevorzugt größer oder gleich 3 mm und kleiner oder gleich 15 mm und weiterhin bevorzugt größer oder gleich 5 mm und kleiner oder gleich 10 mm vom Rand der Trägerplatte bis hin zur Oberflächenmitte der Trägerplatte erstreckt.

In einer bevorzugten Charakteristik des Systems kann die Trägerplatte zumindest abschnittweise gleitend im Aufnahmerahmen mechanisch anordbar sein. Zur Verbesserung des mechanischen Schutzes der Trägerplatte hat es sich als besonders geeignet herausgestellt, wenn diese gleitend in der Trägerplatte gelagert wird. Dazu kann die Trägerplatte bevorzugt an Ihren beiden Oberflächenseiten vom Aufnahmerahmen gehalten werden. In dieser Ausführungsform kann die Trägerplatte bevorzugt durch zwei oder mehr mechanische Kontaktpunkte fixiert werden. Diese Art der gleitenden Lagerung ist im erfindungsgemäßen System günstiger als eine lange Kontaktierungsfläche zwischen Trägerplatte und Aufnahmerahmen. Bevorzugt kann der Aufnahmerahmen auch eine umlaufende Nut aufweisen, welche in ihren Inneren eine oder mehrere Kontakterhebungen aufweist. Durch die Höhe und die Auflagefläche der Kontakterhebungen lassen sich die nötigen mechanischen Kräfte zum Verschieben der Trägerplatte genau steuern. Bevorzugt können diese Kontakterhebungen auch aus einem anderen Material, beispielsweise aus einem gummielastischen Material, ausgeführt sein.

In einer weiter bevorzugten Ausführungsform des Systems kann der Aufnahmerahmen und die Trägerplatte dazu eingerichtet sein, durch Befestigungsmittel miteinander mechanisch verbindbar zu sein. Zur sicheren mechanischen Kontaktierung zwischen Aufnahmerahmen und Trägerplatte hat es sich als besonders günstig herausgestellt, wenn an einer oder mehreren Stellen entlang des umlaufenden Randbereichs der Trägerplatte und dem Aufnahmerahmen Vorrichtungen vorliegen, welche eine lösbare Verbindung zwischen Trägerplatte und Aufnahmerahmen ermöglichen. Die Vorrichtungen können beispielsweise in Form von Halte- oder Ankerpunkten auf den Oberflächen der Trägerplatte und dem Aufnahmerahmen vorhanden sein, welche über mehr oder weniger elastische Verbindungsstücke miteinander verbunden werden. Dazu können beispielsweise Bänder, Gummis, Metallfedern oder Klipse verwendet werden. Alternativ können sowohl die Trägerplatte als auch der Aufnahmerahmen jeweils Nuten aufweisen und die mechanische Verbindung über Stege ausgeführt werden, welche jeweils in die Nuten eingreifen.

In einer weiter bevorzugten Ausgestaltung des Systems kann das System Befestigungsmittel umfassen, wobei die Befestigungsmittel eine Soll-Bruchstelle aufweisen, wobei die Soll-Bruchstelle dazu eingerichtet ist unter mechanischer Belastung die Verbindung zwischen Trägerplatte und Aufnahmerahmen zu lösen. Insbesondere in den Fällen, in denen zwischen der Trägerplatte und dem Aufnahmerahmen ein oder mehrere lösbare mechanische Verbindungen vorliegen, kann es sinnvoll sein, dass diese Verbindungen eine Sollbruchstelle aufweisen. Im Falle einer zu starken mechanischen Belastung kann diese Sollbruchstelle sich lösen und die Trägerplatte und somit die Elektronik vor mechanischen Belastungen schützen. Sollbruchstellen können beispielsweise durch eine gezielte Schwächung in der mechanischen Struktur des Befestigungsmittels erzeugt werden.

In einer bevorzugten Ausführungsform des Systems kann der Aufnahmerahmen zu größer oder gleich 50 Gew.-% und kleiner oder gleich 100 Gew.-% aus einem Kunststoff bestehen, wobei mindestens die die Trägerplatte kontaktierenden Bereiche des Aufnahmerahmens eine Metallbeschichtung aufweisen. Neben der Möglichkeit zur Reduzierung und Optimierung der Trägerplattenfläche, kann der Aufnahmerahmen auch dazu genutzt werden, weitere Funktionalitäten in das System zu integrieren. Eine ortsangepasste Metallbeschichtung am Aufnahmerahmen kann dazu beitragen, dass die elektrische Abschirmung der Elektronik auf der Trägerplatte verbessert wird. Insbesondere unter schwierigen elektrischen Umgebungsbedingungen kann derart ein wirksamer Schutz für die Elektronik bereitgestellt werden, welches die Lebensdauer der elektronischen Vorrichtung erhöht.

In einer weiterhin bevorzugten Charakteristik des Systems kann der Aufnahmerahmen zu größer oder gleich 50 Gew.-% und kleiner oder gleich 90 Gew.-% einen biologisch abbaubaren Kunststoff und zu größer oder gleich 10 Gew.-% und kleiner oder gleich 50 Gew.-% eine oder mehrere wasserabsorbierende Substanzen umfassen. Einen besonders verbesserten Kohlendioxid-Fußabdruck der Trägerplatte erhält man in den Fällen, in denen der Aufnahmerahmen größtenteils aus einem biologisch abbaubaren Kunststoff hergestellt ist. Es kann zudem vorteilhaft sein, wenn der biologisch abbaubare Kunststoff ein biobasierter Kunststoff ist. Bevorzugt können die biologisch abbaubaren Kunststoffe auch den Kriterien der EN 14995:2006 zur Abbaubarkeit entsprechen. Diesem Grundaufbau können dann zweckmäßigerweise wasserabsorbierende Substanzen zugegeben werden, welche die Elektronik auf der Leiterplatte vor Korrosion schützen können. Bevorzugt kommen als wasserabsorbierende Substanzen Superabsorber wie Copolymere aus Acrylsäure (Propensäure, H₂C=CH-COOH) oder Natriumacrylat (Natriumsalz der Acrylsäure, H₂C=CH-COONa) einerseits und Acrylamid in Frage. Alternativ können auch anorganische Salze wie Kupfersulfat, Calciumoxid, Calciumchlorid, oder Soda-Kalk, Kieselgur, Kieselgel, Zinkoxid ZnO, Magnesiumoxid MgO oder Aluminium- oder andere Metallstearate verwendet werden. Wasserabsorbierende Substanzen nehmen bei einer Temperatur von 30°C und einer Luftfeuchte von 85 % innerhalb von einer Stunde mindestes 0,1 g Wasser/g wasserabsorbierende Substanz auf.

In einer weiter bevorzugten Ausgestaltung des Systems kann der Aufnahmerahmen Sensorelemente aufweisen, wobei die Sensorelemente ausgesucht sind aus der Gruppe bestehend aus Temperatursensoren, Feuchtesensoren, mechanischen Kraftsensoren oder Kombinationen mindestens zweier Sensortypen aus dieser Liste. Die Funktionalität des Systems kann des Weiteren dadurch erhöht werden, indem der Aufnahmerahmen weitere elektrische oder mechanische Sensorelemente aufweist. Die Sensoren können die elektrische, thermische oder mechanische Belastung der Trägerplatte oder des Aufnahmerahmens überwachen und beispielsweise im Rahmen einer Wartungsintervallindikation oder Restlebenszeitprognose eingesetzt werden. Zu den Sensoren können weitere Bestandteile, wie beispielsweise eine Speicher-, Anzeige, und/oder Auswertungseinheit treten. Als Temperatursensoren eignen sich beispielsweise Thermofühler oder maximal Farb-Temperaturindikatoren. Feuchtesensoren können elektrische Feuchtemesser oder beispielsweise Farb-Feuchteindikatoren sein. Für die Kraftsensoren bieten sich beispielsweise elektrische Beschleunigungssensoren oder elektrische Kraftaufnehmer oder aber auch Beschichtungen an, welche unter spezifischer Kraftbeaufschlagung Risse oder Verformungen zeigen. Die Sensoren können auf Teilbereichen, auf der gesamten Oberfläche oder im Aufnahmerahmen vorliegen.

In einer bevorzugten Charakteristik des Systems können in einem Aufnahmerahmen mindestens zwei elektronische Trägerplatten anordbar sein. Für die Herstellung und insbesondere zur Bestückung der Trägerplatten hat es sich als besonders günstig herausgestellt, wenn diese schon in einem Aufnahmerahmen angeordnet sind. Die zwei oder mehr Trägerplatten werden durch den Aufnahmerahmen sicher mechanisch gehalten und können parallel bestückt oder bearbeitet werden. Der Aufnahmerahmen kann in diesem Fall als Prozesshilfe und finaler Produktbestandteil ausgestaltet sein. Letzteres kann dadurch erreicht werden, indem der mehrere Trägerplatten aufnehmende Aufnahmerahmen vor dem Einsetzen in das finale elektrische Produkt auf die erforderlichen Produktmaße zugeschnitten wird. Diese Ausgestaltung kann die Prozesszeiten verkürzen und die Produktkosten für Elektronikprodukte verringern.

Beispiele und Ausführungsformen der vorliegenden Erfindung werden noch in exemplarischer Weise mit Bezug auf die Figuren 1 bis 8 beschrieben:
- Figur 1: zeigt schematisch den Aufbau eines erfindungsgemäßen Systems in der Aufsicht;
- Figur 2: zeigt schematisch einen weiteren Aufbau eines erfindungsgemäßen Systems in der Aufsicht;

- Figur 3: zeigt schematisch den Aufbau eines erfindungsgemäßen Systems mit einem Aufnahmerahmen und zwei Trägerplatten in der Aufsicht;
- Figur 4: zeigt schematisch einen weiteren Aufbau eines erfindungsgemäßen Systems mit in dem Aufnahmerahmen integrierten Sensoren;
- Figur 5: zeigt schematisch den Aufbau eines erfindungsgemäßen Systems mit 3D-gedrucktem Aufnahmerahmen zur Aufnahme zweier Trägerplatten mit unterschiedlichen Abmessungen;
- Figur 6: zeigt schematisch den Aufbau eines erfindungsgemäßen Systems im Querschnitt;
- Figur 7: zeigt schematisch einen weiteren Aufbau eines erfindungsgemäßen Systems im Querschnitt;
- Figur 8: zeigt schematisch einen weiteren Aufbau eines erfindungsgemäßen Systems mit Befestigungsmitteln in der Aufsicht.

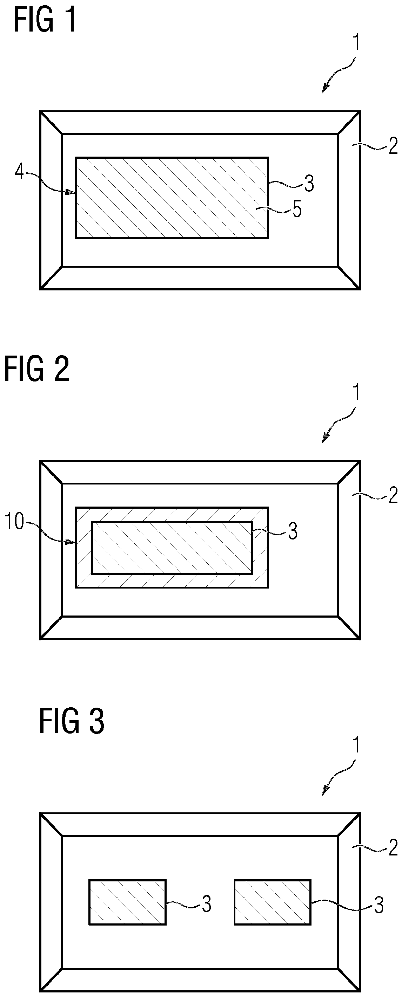

Die Figur 1 zeigt schematisch den Aufbau eines erfindungsgemäßen Systems 1 in der Aufsicht. Das System 1 umfasst einen Aufnahmerahmen 2 und eine in den Aufnahmerahmen 2 eingebettete Trägerplatte 3. Die Größe der Trägerplatte 3 ist von der Einbausituation in einem elektronischen Gerät durch die Einpassung in den Aufnahmerahmen 2 entkoppelt, sodass die Größe der Trägerplatte 3 rein aufgrund der elektronischen Notwendigkeiten gewählt werden kann. Eine Anpassung durch eine gezielte Vergrößerung der Trägerplatte 3 auf die nötige Größe für den Einbau in ein elektrisches Gerät entfällt. Durch die Entkopplung der Größen zwischen Trägerplatte 3 und Einbausituation lassen sich für den Aufnahmerahmen 2 andere Materialien nutzen. Es können beispielsweise biologisch herstellbare und/oder biologisch abbaubare Kunststoffe verwendet werden, welches insgesamt die Nachhaltigkeit und die Recyclingfähigkeit des Gesamtaufbaus des elektronischen Gerätes verbessert. In der Figur ist zudem der Aufbau der Trägerplatte 3 mit einem umlaufenden Rand 4 und einem Oberflächenbereich 5 dargestellt. Der umlaufende Rand 4 der Trägerplatte 3 kontaktiert erfindungsgemäß den Aufnahmerahmen 2 und wird durch diesen in der Einbausituation gehalten. Die Trägerplatte 3 weist zwei, sich gegenüberliegende Oberflächenbereiche 5 auf, wobei mindestens einer der Oberflächenbereiche 5 mit elektronischen Bauteilen bestückt oder bestückbar ist.

Die Figur 2 zeigt schematisch einen weiteren Aufbau eines erfindungsgemäßen Systems 1 in der Aufsicht. Ebenso wie in der Figur 1 umfasst das System 1 einen Aufnahmerahmen 2 und eine in den Aufnahmerahmen 2 eingebettete Trägerplatte 3. Im Unterschied zur Figur 1 zeigt diese Trägerplatte 3 eine andere Geometrie und kleinere Oberfläche. Durch das erfindungsgemäße System 1 lassen sich also flexibel unterschiedliche Trägerplatten 3 in eine Endeinbausituation integrieren. Somit kann mit einem festgelegten Endaufbau die optimale Geometrie der Trägerplatte 3 frei gewählt werden. Des Weiteren ist in der Figur dargestellt, dass der Aufnahmerahmen 2 eine Metallbeschichtung 10 aufweist. Es kann sich beispielsweise um eine partielle Metallbeschichtung 10 handeln, welcher an der direkten Kontaktfläche des Aufnahmerahmens 2 an der Trägerplatte 3 aufgebracht ist. Die Metallbeschichtung 10 kann zu einer besseren elektrischen Abschirmung der elektronischen Bauteile auf der Trägerplatte 3 beitragen. Weiterhin kann über die Metallbeschichtung 10 auch der Wärmeübergang zwischen Trägerplatte 3 und Aufnahmerahmen 2 beeinflusst und gesteuert werden.

Die Figur 3 zeigt schematisch den Aufbau eines erfindungsgemäßen Systems 1 mit einem Aufnahmerahmen 2 und zwei Trägerplatten 3 in der Aufsicht. Der Aufnahmerahmen 2 lässt sich vorteilhafterweise nicht nur für die Verbesserung der Einbausituation nutzen. Der Einsatz eines Aufnahmerahmens 2 kann auch im Rahmen der Herstellung genutzt werden. Ein Aufnahmerahmen 2 kann mehrere Trägerplatten 3 aufnehmen und mechanisch fixieren, sodass eine parallele Verarbeitung oder Bestückung erreicht werden kann. Im Vergleich zu einer rein sequenziellen Produktion können sich somit deutliche Kostensenkungen ergeben.

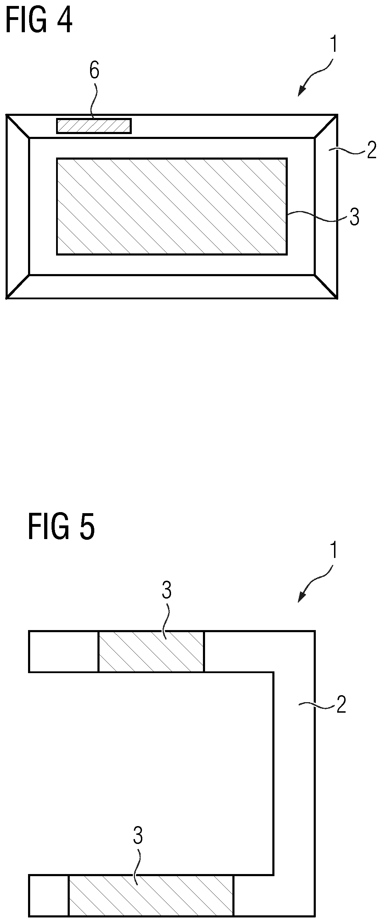

Die Figur 4 zeigt schematisch einen weiteren Aufbau eines erfindungsgemäßen Systems 1 mit in dem Aufnahmerahmen 2 integrierten Sensorelementen 6. Weitere System-Funktionalitäten können durch die Aufnahme von Sensorelementen 6 in den Aufnahmerahmen 2 integriert werden. Der Aufnahmerahmen 2 dient in diesen Fällen nicht nur als mechanische Stütze, sondern kann Informationen über den temporären oder integralen Betriebszustand der auf der Trägerplatte 3 befindlichen Elektronik liefern. Wartungsintervalle können aufgrund der Sensor-Auswertungen festgelegt und voraussichtliche Restlebensdauern bestimmt werden. Prinzipiell können jegliche Art von Sensoren, sei es elektrischer, mechanischer oder chemischer Natur in den Aufnahmerahmen 2 integriert werden.

Die Figur 5 zeigt schematisch den Aufbau eines erfindungsgemäßen Systems 1 mit 3D-gedrucktem Aufnahmerahmen 2 zur Aufnahme zweier Trägerplatten 3 mit unterschiedlichen Abmessungen. Durch die Entkopplung der Materialeigenschaften zwischen Aufnahmerahmen 2 und Trägerplatte 3 können beispielsweise auch 3D-druckbare Materialien zum Aufbau 3-dimensionaler Aufnahmerahmen 2 verwendet werden. Es können so komplexe Einbausituationen umgesetzt werden, welche ein oder mehrere Trägerplatten 3 mit gleichen oder unterschiedlichen Geometrien aufweisen.

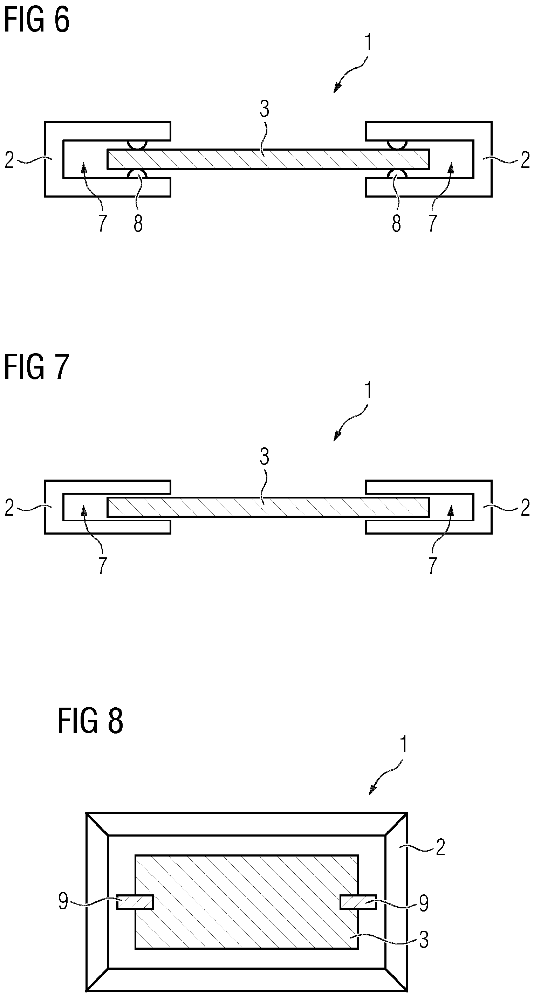

Die Figur 6 zeigt schematisch den Aufbau eines erfindungsgemäßen Systems 1 im Querschnitt. Es ist dargestellt, dass die mechanische Kontaktierung zwischen Trägerplatte 3 und Aufnahmerahmen 2 nicht zwingend über den umlaufenden Rand 4 der Trägerplatte 3 erfolgen muss. Der Aufnahmerahmen 2 weist eine Nut 7 auf, in welche die Trägerplatte 3 eingeschoben ist. Der Aufnahmerahmen 2 kontaktiert die Trägerplatte 3 in diesen Fällen auf beiden Oberflächenbereichen 5 der Trägerplatte 3. Die mechanische Kontaktierung erfolgt über Kontakterhebungen 8, welche sich in die Nut 7 hinein erstrecken und letztendlich die Oberflächenbereiche 5 kontaktieren. Der Kontakt erfolgt an den Randbereiche der Trägerplatte 3 aber nicht am umlaufenden Rand 4 der Trägerplatte 3. Durch diese Ausgestaltung ergibt sich eine gleitende Lagerung der Trägerplatte 3, welche bei starker mechanischer Belastung des elektronischen Produktes die Trägerplatte 3 vor mechanischen Belastungen schützen kann.

Die Figur 7 zeigt schematisch einen weiteren Aufbau eines erfindungsgemäßen Systems im Querschnitt. Auch in dieser Ausgestaltung kontaktiert der Aufnahmerahmen 2 die Trägerplatte 3 nicht am umlaufenden Randbereich 4. Die Kontaktierung erfolgt über beide Oberflächenbereiche 5 der Trägerplatte 3. Dazu ist in dem Aufnahmerahmen 2 eine Nut 7 vorgesehen, welche die Trägerplatte 3 an ihren Randbereichen aufnimmt. Durch die Kontaktierung innerhalb der Nut 7, wird die Trägerplatte 3 gleitend gelagert und kann so vor starker mechanischer Belastung geschützt werden.

Die Figur 8 zeigt schematisch einen weiteren Aufbau eines erfindungsgemäßen Systems 1 mit Befestigungsmitteln 9 in der Aufsicht. Neben der rein mechanischen Kontaktierung der Trägerplatte 3 durch den Aufnahmerahmen 2 können noch Befestigungsmittel 9 in das System 1 integriert werden, welche ein verbessertes Halten der Trägerplatte 3 in den Aufnahmerahmen 2 bewirken. Es kann sich beispielsweise um elastische Bänder, Federn oder Haltebolzen handeln. In einer bevorzugten Ausführungsform können die Befestigungsmittel 9 dazu eingerichtet sein bei einer spezifischen mechanischen Belastung zu brechen und so die Trägerplatte 3 vom Aufnahmerahmen 2 mechanisch zu entkoppeln.

### Bezugszeichenliste

- 1: System
- 2: Aufnahmerahmen
- 3: Trägerplatte
- 4: umlaufender Randbereich
- 5: Oberflächenbereich
- 6: Sensor
- 7: Nut
- 8: Kontakterhebung
- 9: Befestigungsmittel
- 10: Beschichtung

## Patentansprüche

1. System (1) aus einer elektronischen Leiterplatte und einem Aufnahmerahmen (2), **dadurch gekennzeichnet, dass** die elektronische Leiterplatte eine Trägerplatte (3) mit zwei Oberflächenbereichen (5) und einem die Trägerplatte (3) begrenzenden, umlaufenden Randbereich (4) umfasst, wobei auf mindestens einem der Oberflächenbereiche (5) der Trägerplatte (3) elektronische Bauteile anordbar sind, wobei der Aufnahmerahmen (2) den umlaufenden Randbereich (4) der Trägerplatte (3) zu einem Anteil von größer oder gleich 50% bezogen auf den Gesamtumfang des Randbereiches kontaktiert, wobei das Material des Aufnahmerahmens (2) ausgesucht ist aus der Gruppe bestehend aus Metallen, Kunststoffen, biologisch abbaubaren Kunststoffen oder Mischungen mindestens zweier Komponenten aus dieser Liste.

2. System nach Anspruch 1, wobei der Aufnahmerahmen (2) den umlaufenden Randbereich (4) der Trägerplatte (3) vollständig kontaktiert.

3. System nach einem der vorhergehenden Ansprüche, wobei der Aufnahmerahmen (2) die Trägerplatte (2) zumindest abschnittweise an beiden Oberflächenbereichen (5) kontaktiert.

4. System nach einem der vorhergehenden Ansprüche, wobei die Trägerplatte (3) zumindest abschnittweise gleitend im Aufnahmerahmen (2) mechanisch anordbar ist.

5. System nach einem der vorhergehenden Ansprüche, wobei der Aufnahmerahmen (2) und die Trägerplatte (3) dazu eingerichtet sind durch Befestigungsmittel (9) miteinander mechanisch verbindbar zu sein.

6. System nach Anspruch 5, wobei das System Befestigungsmittel (9) umfasst, wobei die Befestigungsmittel (9) eine Soll-Bruchstelle aufweisen, wobei die Soll-Bruchstelle dazu eingerichtet ist unter mechanischer Belastung die Verbindung zwischen Trägerplatte (3) und Aufnahmerahmen (2) zu lösen.

7. System einem der vorhergehenden Ansprüche, wobei der Aufnahmerahmen (2) zu größer oder gleich 50 Gew.-% und kleiner oder gleich 100 Gew.-% aus einem Kunststoff besteht, wobei mindestens die die Trägerplatte (3) kontaktierenden Bereiche des Aufnahmerahmens (2) eine Metallbeschichtung (10) aufweisen.

8. System nach einem der vorhergehenden Ansprüche, wobei der Aufnahmerahmen (2) zu größer oder gleich 50 Gew.-% und kleiner oder gleich 90 Gew.-% einen biologisch abbaubaren Kunststoff und zu größer oder gleich 10 Gew.-% und kleiner oder gleich 50 Gew.-% eine oder mehrere wasserabsorbierende Substanzen umfasst.

9. System nach einem der vorhergehenden Ansprüche, wobei der Aufnahmerahmen (2) Sensorelemente (6) aufweist, wobei die Sensorelemente (6) ausgesucht sind aus der Gruppe bestehend aus Temperatursensoren, Feuchtesensoren, mechanischen Kraftsensoren oder Kombinationen mindestens zweier Sensortypen aus dieser Liste.

10. System nach einem der vorhergehenden Ansprüche, wobei in einem Aufnahmerahmen (2) mindestens zwei Trägerplatten (3) anordbar sind.
